**Europäisches Patentamt**

**European Patent Office**

**Office européen des brevets**

(19)

(11) Numéro de publication : **0 307 354 B1**

## FASCICULE DE BREVET EUROPEEN

(12)

(45) Date de publication du fascicule du brevet :
**15.04.92 Bulletin 92/16**

(51) Int. Cl.$^5$ : **G02B 21/24, H01L 41/08**

(21) Numéro de dépôt : **88810580.6**

(22) Date de dépôt : **23.08.88**

(54) **Dispositif de réglage fin d'une unité par rapport à un système de référence et utilisation de ce dispositif.**

(30) Priorité : **25.08.87 FR 8711893**

(43) Date de publication de la demande :
**15.03.89 Bulletin 89/11**

(45) Mention de la délivrance du brevet :
**15.04.92 Bulletin 92/16**

(84) Etats contractants désignés :
**AT BE CH DE ES FR GB GR IT LI LU NL SE**

(56) Documents cités :
**DE-A- 3 614 996**
**FR-A- 2 307 280**

(73) Titulaire : **CENTRE SUISSE D'ELECTRONIQUE ET DE MICROTECHNIQUE S.A.**
**Maladière 71**
**CH-2000 Neuchâtel 7 (CH)**

(72) Inventeur : **Choffat, Hubert**
**Rue de Chasselas 1**
**CH-2014 Bôle (CH)**

(74) Mandataire : **Brulliard, Joel**
**c/o CENTRE SUISSE D'ELECTRONIQUE ET DE MICROTECHNIQUE S.A. Maladière 71**
**CH-2007 Neuchâtel (CH)**

## Description

L'invention concerne les dispositifs de réglage fin d'une unité par rapport à un système de référence. Elle concerne également une utilisation du dispositif selon l'invention.

Les dispositifs connus du type considéré et permettant de régler rapidement et avec précision une unité par rapport à un système de référence par des déplacements de l'ordre du micron, présentent les inconvénients d'être complexes, donc onéreux, et le plus souvent encombrants. Par ailleurs, ils ne se prêtent pas toujours à une commande asservie.

Le document DE-A-3 614 996 et, plus particulièrement, le document FR-A-2 307 280 montre un dispositif de réglage fin d'une unité par rapport à un système de référence conforme au préambule de la revendication 1.

Dans les microscopes, en particulier, la mise au point de l'objectif s'effectue à l'aide d'une vis de réglage fin. Un petit déplacement angulaire de cette vis peut toutefois produire un déplacement de l'objectif de plusieurs microns.

Un but de l'invention est de réaliser un dispositif de réglage fin qui soit relativement mince, à commande électrique et de faible coût. L'élément piézoélectrique défini par la revendication 1 y parvient, en raison, d'une part, de la proportionnalité entre les tensions appliquées à l'élément piézoélectrique et les déformations de ce dernier, et, d'autre part, de la forte démultiplication entre ces tensions et lesdites déformations. En d'autres termes, une augmentation sensible de la tension appliquée à l'élément piézoélectrique n'en produit qu'un infime accroissement de déformation.

Un autre but de l'invention est de réaliser un dispositif d'ajustement fin de la position angulaire d'une unité par rapport à un système de référence.

Un autre but de l'invention est l'utilisation du dispositif dans un microscope en vue de réaliser rapidement une focalisation suivant plusieurs plans superposés.

L'élément piézoélectrique à formes spéciales d'exécution est particulièrement intéressant en raison de la plage étendue sur plusieurs microns de ses déformations. Il peut notamment s'incurver dans l'un et l'autre sens, en inversant simplement la polarité de la tension qui lui est appliquée.

Le dispositif selon les formes spéciales d'exécution a l'avantage de commander des déplacements en translation pure, outre celui d'être peu encombrant.

Les formes spéciales d'exécution ont l'avantage de doubler l'effort exercé par les éléments piézoélectriques sur l'anneau métallique qui les supporte.

L'utilisation définie par la revendication 7 permet de focaliser l'objectif du microscope soit en continu sur tous les plans de l'objet observé soit sur un ou plusieurs plans particuliers.

Deux formes d'exécution du dispositif selon l'invention sont représentées schématiquement et à simple titre d'exemple au dessin annexé, qui représente aussi deux exemples de l'utilisation selon l'invention.

La Fig. 1 est une vue de la première forme d'exécution du dispositif selon l'invention en coupe diamétrale, selon la ligne I-I de la Fig. 2.

La Fig. 2 est une coupe selon la ligne II-II de la Fig. 1.

La Fig. 3 est un développement d'une partie de la Fig. 2, coupée selon le cercle en traits mixtes, puis déroulée à partir des flèches III.

Les Fig. 4, 4a, 4b sont des coupes similaires à celle de la Fig. 1, qui illustrent le mode de fonctionnement de la première forme d'exécution du dispositif selon l'invention.

La Fig. 5 est une coupe diamétrale d'une partie de la seconde forme d'exécution.

La Fig. 6 est une vue en perspective du premier exemple d'utilisation du dispositif selon l'invention.

La Fig. 7 est une vue analogue à celle de la Fig. 6 du second exemple d'utilisation du dispositif selon l'invention.

La Fig. 8 est une vue en plan à plus grande échelle d'un organe de la Fig. 7.

La Fig. 9 est une représentation schématique d'une application particulièrement intéressante du dispositif de l'invention.

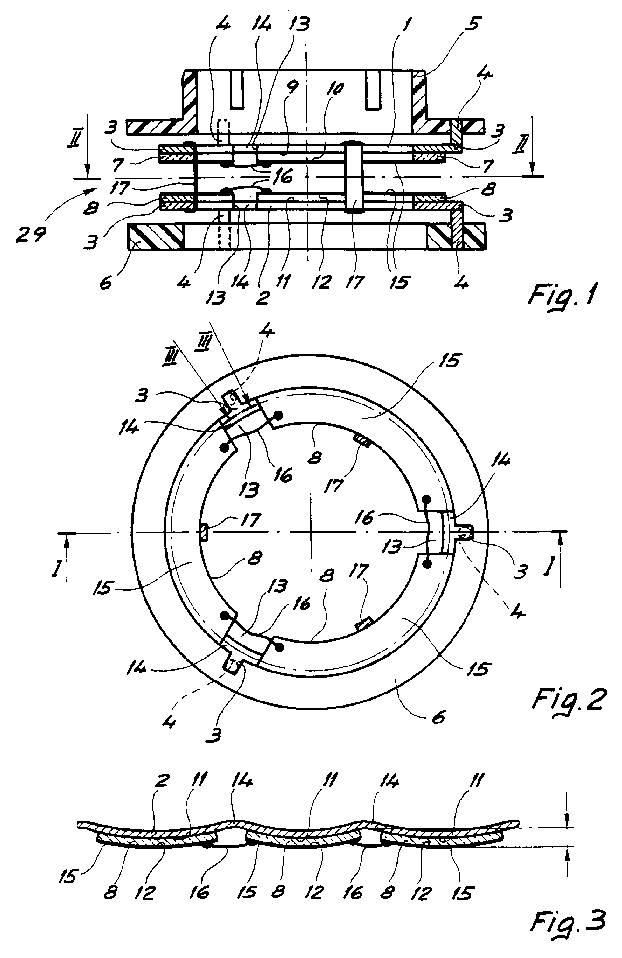

Le dispositif représenté aux Fig. 1 et 2 comprend deux anneaux plats, 1, 2 identiques et parallèles entre eux. Leur profil général a la forme d'un rectangle allongé; ils sont faits en un métal bon conducteur d'électricité, mécaniquement stable et de bonne élasticité. Chacun des anneaux 1, 2 présente trois oreilles 3, qui sont régulièrement réparties à sa périphérie. Chaque oreille 3 est munie d'un pied 4. Les oreilles 3 et les pieds 4 de l'anneau 1 servent à fixer rigidement celui-ci à un organe 5 faisant partie d'un système de référence (non représenté). Les oreilles 3 et les pieds 4 de l'anneau 2 servent de même à fixer rigidement ce dernier à un organe 6 faisant partie d'une unité (non représentée) pouvant se déplacer en translation pure par rapport audit système de référence.

Un ensemble de trois éléments piézoélectriques identiques 7, 8, plats, en forme de secteurs de couronne circulaire, sont fixés à chacun des anneaux 1, 2, par leurs faces en regard l'une de l'autre (Fig. 1), par exemple à l'aide d'une colle conductrice d'électricité. Chacun des éléments 7, 8 est conditionné de manière à ce que l'application d'une tension électrique entre ses faces planes 9, 10 / 11, 12 en produise une incurvation dans un sens ou dans l'autre, selon la polarité de cette tension, comme représenté à la Fig. 3. La Fig. 2 montre que les éléments 8 ne se touchent pas; il en va naturellement de même des éléments 7. Les éléments 7, 8 répartis régulièrement autour des anneaux 1, 2, s'étendent entre les oreilles 3.

Il convient de noter que les anneaux 1, 2 couvrent exactement les faces 9, 11 des éléments respectifs 7, 8. Chaque anneau 1, 2 présente ainsi trois découpures 13 en regard des oreilles 3, pour réduire la résistance à la flexion des parties 14 des anneaux 1, 2 s'étendant entre les éléments 7, 8.

Il résulte de la description précédente que les anneaux 1, 2 constituent chacun l'une des électrodes des groupes de trois éléments respectifs 7, 8 qu'il porte. L'autre électrode de ces éléments est constituée par une fine couche métallique 15 vaporisée sur les faces 10, 12 des éléments respectifs 7, 8. Les couches 15 des éléments 7, 8 de chacun des anneaux 1, 2 sont connectées entre elles par des fils conducteurs 16, soudés aux couches 15. Les anneaux 1, 2, d'une part, et les couches 15, d'autre part, sont connectés par des conducteurs (non représentés) à une source de tension (non représentée).

Trois barrettes 17, identiques, relient rigidement l'anneau 1 à l'anneau 2. Comme le montre en particulier la Fig. 2, les barrettes 17 se trouvent au milieu de la longueur des éléments 7, 8. Les oreilles 3 de l'un des anneaux 1, 2 sont ainsi exactement en regard des oreilles 3 de l'autre anneau. Dans la Fig. 1, les éléments piézoélectriques 7 sont aussi chacun exactement au-dessus d'un élément 8. Si les barrettes 17 sont conductrices d'électricité, les anneaux 1 et 2 ont la même polarité. En créant une différence de potentiel entre les anneaux 1, 2 d'une part, et les couches 15, d'autre part, les éléments 7, 8 s'incurveront donc en sens inverses.

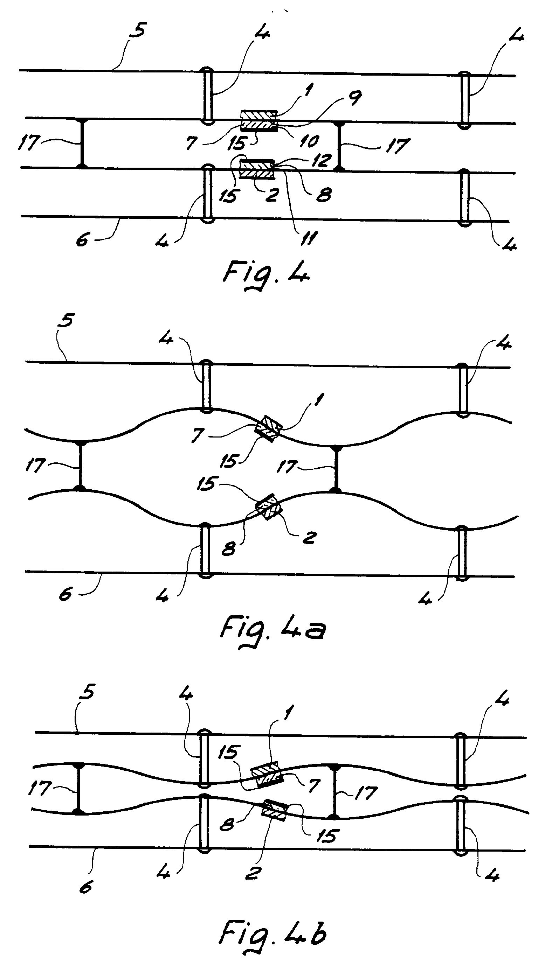

Les réactions du dispositif décrit ci-dessus et représenté à la Fig. 1, lors de l'application d'une différence de potentiel entre les anneaux 1, 2, d'une part, et les couches 15, d'autre part, sont illustrées de façon fortement exagérée aux Fig. 4, 4a, 4b. En Fig. 4, qui correspond à la Fig. 1, les anneaux 1, 2 et les couches 15 sont au même potentiel; les éléments 7, 8 sont plats.

Si une tension de polarité convenable est appliquée aux électrodes constituées par les anneaux 1, 2 et par les couches 15, les éléments 7, 8 s'incurvent en sens inverses, comme le montre la Fig. 4a. Entre deux pieds 4, les éléments 7 s'incurvent vers le bas et les éléments 8 vers le haut. Comme les milieux de ces éléments 7, 8 sont maintenus à une distance déterminée les uns des autres par les barrettes 17, l'organe 6 s'éloigne de l'organe 5.

Si la polarité de la tension appliquée aux anneaux 1, 2 et aux couches 15 est inversée, les éléments 7, 8 s'incurvent en sens contraires par rapport au cas précédent et l'organe 6 se rapproche de l'organe 5, comme le montre la Fig. 4b.

Dans le cas d'anneaux 1, 2 munis de leurs éléments 7, 8, ayant un diamètre extérieur de 36 mm, une largeur de 7 mm et une épaisseur totale de 1 mm, le déplacement maximum de l'organe 6 de la Fig. 4a à la Fig. 4b peut atteindre 20 microns pour des tensions variant de -150 Volts à +150 Volts. L'organe 6 sera ainsi déplacé de 1 micron par rapport à l'organe 5 pour une variation de tension de 15 Volts. Il serait aisé de doubler cette variation de tension pour un déplacement de 1 micron de l'organe 6 par rapport à l'organe 5, afin d'augmenter la sensibilité du réglage. Il suffirait à cet effet de bloquer la tension appliquée, par exemple, aux éléments piézoélectriques 8 et de ne faire varier que celle appliquée alors aux éléments piézoélectriques 7.

Selon les utilisations du dispositif de l'invention, un seul des anneaux 1, 2, par exemple l'anneau 1, peut suffire. Les points milieux des éléments 7 qu'il porte seront alors reliés rigidement, directement à l'organe de l'unité à déplacer par rapport au système de référence. Dans une telle exécution, les déplacements de l'unité en question sont naturellement réduits de moitié par rapport à l'exécution décrite précédemment.

Lorsque l'unité en question doit être déplacée en translation pure par rapport au système de référence et selon ses dimensions et/ou sa forme, le nombre des éléments piézoélectriques par électrode-support pourrait être supérieur à trois. Ces éléments pourraient aussi avoir une forme rectangulaire au lieu de celle représentée au dessin et être fixés aux côtés d'électrodes-supports carrées ou en forme de polygones réguliers.

Il n'est pas indispensable que les éléments piézoélectriques soient séparés les uns des autres comme dans l'exemple des Fig. 1 et 2; ils pourraient tout aussi bien se toucher.

Enfin, s'il s'agissait, non plus de déplacer l'unité en question en translation par rapport audit système de référence, mais par exemple d'en modifier finement la position angulaire par rapport à ce système, un seul élément piézoélectrique, éventuellement un couple de tels éléments (comme une paire d'éléments 7, 8 [Fig. 1]), éloignés de l'axe de pivotement de ladite unité, pourrait suffire. Une telle exécution pourrait convenir pour régler finement l'inclinaison d'un miroir ou d'un prisme dans un instrument d'optique.

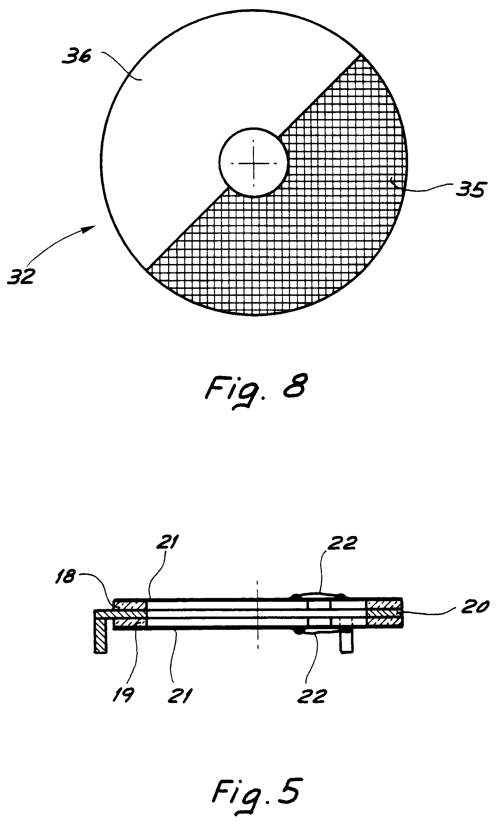

La seconde forme d'exécution du dispositif selon l'invention, qui est représentée à la Fig. 5, diffère de la première en ce sens que des éléments piézoélectriques 18, 19 sont fixés aux deux faces d'une même électrode-support 20 (anneau ou cadre). Comme dans la première forme d'exécution, la seconde électrode des éléments 18, 19 est ici aussi réalisée par une fine couche métallique 21 vaporisée sur ces éléments et ces secondes électrodes sont aussi connectées entre elles par des fils conducteurs 22, soudés aux couches 21. Afin que les éléments piézoélectriques 18, 19 s'incurvent dans le même sens sous l'effet d'une tension électrique appliquée entre le support 20 et les couches 21, il importe toutefois que la polarité des éléments 18 soit l'inverse de celle des éléments 19.

Cette exécution à l'avantage d'accentuer l'effort des éléments piézoélectriques 18, 19 sur leur support 20.

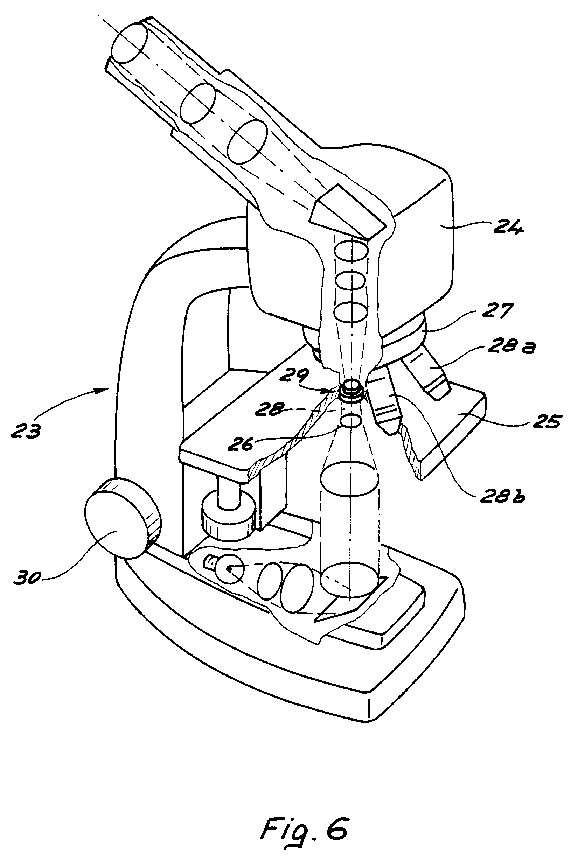

Le premier exemple d'utilisation selon l'invention est représenté à la Fig. 6. Cet exemple est constitué par un microscope monoculaire 23 de type bien connu. Le microscope 23 comprend notamment une tête 24, qui peut être déplacée perpendiculairement à une table 25, sur laquelle sont déposés les objets 26 à observer. Une tourelle 27, munie de trois objectifs 28, 28a, 28b, est montée rotativement sur la tête 24. Chacun des objectifs 28, 28a, 28b peut être amené dans l'axe optique du microscope 23 par rotation de la tourelle 27.

Entre l'objectif 28 et la tourelle 27 est intercalé le dispositif 29 représenté à la Fig. 1. Le système de référence, dans cet exemple d'utilisation, comprend la tête 24 du microscope 23. L'organe 5 de la Fig. 1 est soit la tourelle 27 du microscope 23 soit une pièce intermédiaire, fixée rigidement à cette tourelle. De même, l'organe 6 de la Fig. 1 est une partie de l'unité à déplacer, qui est constituée par l'objectif 28 ou par une pièce intermédiaire fixée rigidement, mais de manière amovible, à cet objectif. Cet objectif 28 n'est ainsi tenu et guidé que par le dispositif 29, c'est-à-dire par les pieds 4 et les barrettes 17.

La mise au point du microscope 23 s'effectue en focalisant grossièrement l'objectif 28 sur l'objet 26 à l'aide de la vis 30. Le dispositif 29 permet alors de focaliser l'objectif 28 exactement sur n'importe quel plan de l'objet 26. L'épaisseur de cet objet peut ainsi être observée successivement à chaque niveau ou à certains niveaux bien déterminés, simplement en variant la tension appliquée aux éléments piézoélectriques 7, 8, ce qui peut être réalisé aisément et rapidement, par exemple à l'aide d'un variateur de tension standard (non représenté).

Le microscope 23 peut ne présenter qu'un seul dispositif 29. Si l'on désire remplacer l'objectif 28 par l'un ou l'autre des objectifs 28a, 28b, il suffit de séparer l'objectif désiré de la tourelle 27 et de le substituer à l'objectif 28. Chacun des objectifs 28, 28a, 28b peut toutefois être relié à la tourelle 27 par un dispositif 29.

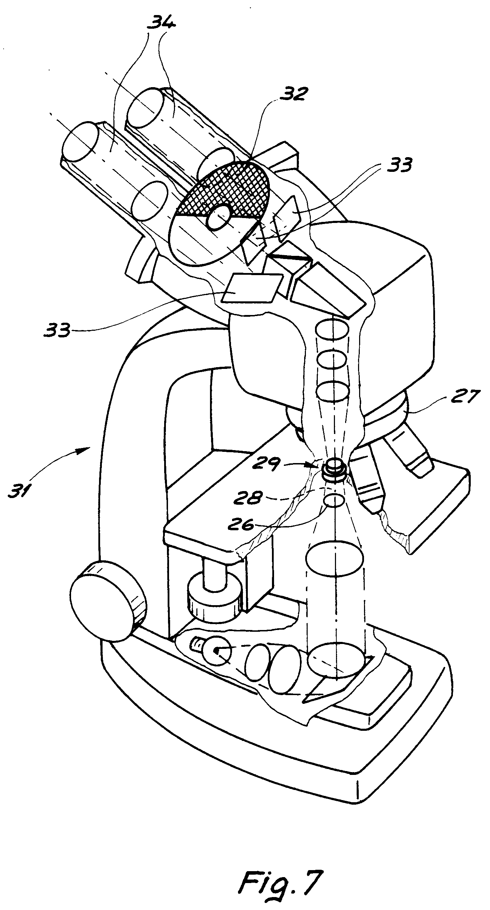

Le second exemple d'utilisation selon l'invention (Fig. 7) est constitué par un microscope binoculaire 31 de type bien connu. Tout comme le microscope 23 du premier exemple, il comprend aussi un dispositif 29 intercalé entre l'objectif 28, situé dans l'axe optique du microscope 31, et la tourelle 27.

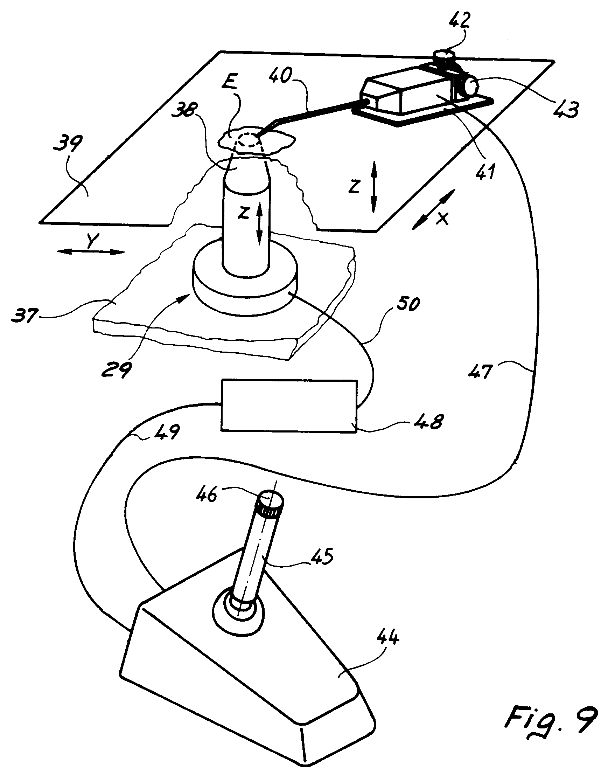

Dans un but décrit ci-après, le microscope 31 est encore équipé d'un obturateur 32, qui est disposé entre les miroirs 33 et les oculaires 34 et s'étend à travers les chemins optiques allant de ces miroirs 33 aux oculaires 34. L'obturateur 32 est représenté à la Fig. 8. Il est constitué par un disque entraîné en rotation de façon bien connue des hommes du métier, à partir d'un moteur électrique (non représenté) à l'aide de moyens mécaniques (non représentés). Ce disque présente une moitié 35, opaque, et une autre moitié 36, transparente.

Ce second exemple d'utilisation est principalement destiné à observer comme objet 26 des pièces présentant deux surfaces planes à des niveaux différents. L'objectif 28 est focalisé alternativement sur l'une et l'autre de ces deux surfaces planes, en envoyant aux éléments piézoélectriques 7, 8 du dispositif 29 des impulsions de tension appropriées et cela à une fréquence au moins égale à 25 Hertz. La source (non représentée) qui émet ces impulsions destinées aux éléments 7, 8 en émet aussi à l'intention du moteur qui entraîne l'obturateur 32, de façon à actionner celui-ci en synchronisme avec l'objectif 28.

Quand cet objectif 28 est ainsi focalisé sur l'une des deux dites surfaces planes de l'objet 26, la partie opaque 35 de l'obturateur 32 masque l'un des oculaires 34, tandis que la partie 36 de cet obturateur 32 libère le chemin optique de l'autre oculaire 34. Quand, d'autre part, l'objectif 28 est focalisé sur l'autre des dites surfaces planes de l'objet 26, la partie opaque 35 de l'obturateur 32 masque l'autre oculaire, tandis que la partie transparente 36 de l'obturateur 32 libère le chemin optique du premier oculaire 34.

Un oeil de l'observateur verra ainsi l'une des deux dites surfaces planes de l'objet 26 son autre oeil recevra l'image de l'autre surface plane. Ces perceptions ne sont évidemment pas continues, mais interrompues périodiquement par la partie opaque 35 de l'obturateur 32. La durée de ces interruptions est toutefois inférieure à la persistance rétinienne, si bien que l'observateur a l'illusion de voir à la fois deux plans différents de l'objet, ce que peut, dans une certaine mesure, être assimilé à une vision "stéréoscopique".

Les impulsions envoyées au moteur actionnant l'obturateur 32 peuvent être de nature à faire tourner ce dernier rapidement, chaque fois de 180°, puis à l'arrêter un bref instant, c'est-à-dire à le faire tourner pas à pas. Celles envoyées aux éléments piézoélectriques 7, 8 peuvent être de profil carré, rectangulaire ou trapézoïdal. Des essais ont toutefois révélé qu'une tension sinusoïdale donnait également des résultats satisfaisants.

D'autres utilisations du dispositif selon l'invention que les deux exemples décrits et représentés apparaîtront à l'homme du métier. Outre les utilisations déjà évoquées au cours de la description des formes d'exécution du dispositif selon l'invention elle-même, celui-ci pourrait encore être utilisé. pour effectuer des microdéplacements, tels que requis en optique, en optique-électronique ou pour les techniques de génie biologique.

Un exemple d'une application de l'invention particulièrement intéressant dans ces techniques est illustré sur la Fig. 9.

Comme dans les exemples des Fig. 6 à 8, le dispositif 29 selon l'invention est placé entre le bâti 37 du microscope et son objectif 38. Ce dernier est pointé sur une tablette de travail 39 sur laquelle est déposé un échantillon E quelconque, par exemple un échantillon de tissu biologique sur lequel une opération, telle qu'une coupe, une injection ou extraction de substance ou autre, doit être effectuée.

La tablette de travail 39 est équipée d'un outil 40 (ici une pipette, par exemple) porté par un support d'outil 41 qui est conçu pour assurer également un pré-positionnement de l'outil, réglable à l'aide de vis 42 et 43.

Le support d'outil 41 est connecté à un manipulateur 44 pourvu d'une manette de commande 45 et d'un bouton de commande 46. Ce manipulateur 44, connu en soi comme l'est d'ailleurs le support d'outil 41, est relié à ce dernier par une connexion pneumatique ou électrique 47 sur laquelle sont véhiculés des signaux de réglage fin en X, Y, et Z engendrés dans le manipulateur par la manette 45 (direction X-Y) et le bouton 46 (direction Z). Ainsi, l'opérateur peut placer la pointe de l'outil 40 à un point quelconque de l'espace au-dessus de la tablette 39, par exemple pour prélever dans l'échantillon E une portion qu'il faut analyser plus en détail.

Le réglage fin de netteté du microscope par le dispositif 29 se faisant par un déplacement de l'objectif 38 dans la direction Z, il devient possible d'exploiter le signal de réglage selon cette direction de l'outil 40 par le bouton 46, pour asservir la netteté de l'image du microscope aux déplacements de la pointe de l'outil 40 choisis par l'opérateur.

A cet effet, le manipulateur 44 est raccordé à un bloc d'asservissement 48 par une connexion 49 sur laquelle transite le signal de réglage de la direction Z. Le bloc d'asservissement 48 est agencé pour transformer ce signal de réglage en un signal de tension variable utilisable par le dispositif 29, signal de tension qui est appliqué au moyen d'une connexion 50.

Ainsi, à chaque déplacement en Z de la pointe de l'outil correspond un déplacement en Z de l'objectif qui ramène la pointe de l'outil 40 dans le plan objet du microscope. L'opérateur dispose donc d'une façon continue et d'une manière très simple d'une image nette de l'action qu'il effectue sur l'échantillon.

Bien entendu, l'outil 40 peut être quelconque et toute micro-action peut être effectuée à l'aide de l'installation illustrée sur la Fig. 9 à condition de monter dans le support 41 l'outil correspondant (micro-pince, par exemple).

Une autre application du dispositif suivant l'invention pourrait concerner le domaine des circuits intégrés et notamment le contrôle de leurs connexions électriques qui sont souvent situées à deux niveaux distincts. Par conséquent, en appliquant au dispositif suivant l'invention intégré dans le microscope de contrôle comme décrit ci-dessus, deux tensions distinctes au choix de l'opérateur, ce dernier peut facilement avec un bon confort d'utilisation mettre au point sélectivement sur les plans des deux niveaux des connexions du circuit intégré. Cette sélection pourra facilement être mise en oeuvre à l'aide d'un simple inverseur commandé par un bouton à deux positions, par exemple.

Dans le même domaine, le dispositif suivant l'invention peut être utilisé avec profit pour le contrôle du bon positionnement des masques à l'aide desquels les circuits intégrés sont fabriqués. On sait que ce postionnement se fait à l'aide de repères prévus sur le masque et le substrat semi-conducteur. Ces repères sont mis en coïncidence sous microscope par approximations successives qui nécessitent une mise au point alternée par l'opérateur sur la surface du substrat et sur le masque qui, lors du positionnement, se trouve à environ 50 microns de ce substrat.

En utilisant le dispositif suivant l'invention commandé avec deux tensions choisies au gré de l'opérateur, cette mise au point alternée peut très commodément être obtenue sans fatigue pour l'opérateur. Le nombre d'itérations de mise au point lors du positionnement peut de ce fait être réduit par rapport à celui nécessaire avec une mise au point classique du microscope et il en résulte ainsi un autre avantage constitué par une réduction de l'usure des masques et, bien entendu, un gain de temps considérable.

## Revendications

1. Dispositif de réglage fin d'une unité par rapport à un système de référence comprenant une pluralité d'éléments piézoélectriques (7, 8; 18, 19) minces disposés entre un premier organe (5) solidaire dudit système de référence et un deuxième organe (6) solidaire de ladite unité, une première et une deuxième électrodes étant prévues sur lesdits éléments piézoélectriques, lesdits éléments piézoélectriques et lesdites électrodes étant adaptés à s'incurver en réponse à une tension appliquée entre lesdites première et deuxième électrodes; **caractérisé en ce que:**

 – les éléments piézoélectriques (7, 8; 18, 19) minces sont disposés entre ledit premier organe (5) et ledit deuxième organe (6) soit dans un plan (8), soit dans deux plans (7,8;18,19); et ont la forme de segments de couronne circulaire répartis régulièrement sur un (14; 20) ou deux (1,2) anneaux métalliques et fixés à leur anneaux respectif par leurs faces en regard l'une de l'autre; et
 – les première et deuxième électrodes prévues sur lesdits éléments piézoélectriques, sont constituées, respectivement, par le(s) dit(s) anneau(x) métallique(s) (respectifs) et par une métallisation (15) de la deuxième face desdits éléments piézoélectriques de manière à former soit une pluralité d'électrodes, chacune d'elles étant associée à un élément piézoélectrique; soit une seule électrode commune aux éléments piézoélectriques d'un même plan;

de manière à permettre un déplacement en translation de ladite unité combiné ou non à une modification de la position angulaire de ladite unité par rapport audit système de référence.

2. Dispositif selon la revendication 1, caractérisé en ce qu'il comporte un seul anneau métallique (20), en ce que lesdits éléments piézoélectriques (7, 8) sont au nombre de trois et sont séparés les uns des autres, en ce que ledit anneau métallique comporte trois oreilles (3) de fixation à l'un desdits premier et deuxième organes disposées entre lesdits éléments piézoélectriques et en ce qu'il est fixé à l'autre desdits premier et deuxième organes en trois points situés entre lesdites trois oreilles.

3. Dispositif selon la revendication 1, caractérisé en ce qu'il comporte un seul anneau métallique (20), en ce que lesdits éléments piézoélectriques (18, 19) sont fixés sur les deux faces dudit anneau métallique (20) de manière symétrique par rapport audit anneau et en ce que les éléments piézoélectriques symétriques situés de part et d'autre dudit anneau sont inversement polarisés.

4. Dispositif selon la revendication 3, caractérisé en ce que les éléments piézoélectriques adjacents sont en nombre pair et sont inversement polarisés.

5. Dispositif selon la revendication 1, caractérisé en ce que les tensions appliquées entre lesdites première et deuxième électrodes sont identiques et en ce que les déplacements de ladite unité sont dans l'axe dudit dispositif.

6. Dispositif selon la revendication 1, caractérisé en ce que les tensions appliquées entre lesdites première et deuxième électrodes sont telles que la position angulaire de ladite unité est modifiée par rapport à l'axe dudit dispositif.

7. Microscope binoculaire pour l'observation simultanée de deux plans d'un même objet, caractérisé en ce qu'il comporte un dispositif selon la revendication 1 placé entre l'objectif et le corps du microscope de manière à changer son plan focal en réponse à une tension appliquée auxdits éléments piézoélectriques et en ce que des moyens sont prévus pour obturer successivement chacun des deux oculaires en synchronisme avec une variation desdites tensions appliquées de sorte que l'image dudit objet dans deux plans focaux différents puisse être vue simultanément à travers les deux oculaires du microscope.

8. Microscope binoculaire selon la revendication 7, caractérisé en ce que les moyens d'obturation comprennent un disque (32) présentant une moitié transparente et une autre moitié opaque et sont entraînés en rotation à la même fréquence que celle desdites tensions appliquées.

**Patentansprüche**

1. Vorrichtung zur Feinregulierung einer Einheit relativ zu einem Referenzsystem, umfassend eine Merzahl dünner piezoelektrischer Elemente (7, 8; 18, 19), die zwischen einem ersten mit dem Referenzsystem verbundenen Organ (5) und einem zweiten mit der Einheit verbundenen Organ (6) angeordnet sind, wobei eine erste un eine zweite Elektrode auf den piezoelektrischen Elementen vorgesehen sind un wobei die piezoelektrischen Elemente und die Elektroden ausgebildet sind, sich im Ansprechen auf eine zwischen der ersten und der zweiten Elektrode angelegte Spannung zu krümmen, dadurch gekennzeichnet daß

– die dünnen piezoelektrischen Elemente (7, 8; 18, 19) zwischen dem ersten Organ (5) und dem zweiten Organ (6) entweder in einer Ebene (8) oder in zwei Ebenen (7, 8; 18, 19) angeordnet sind und die Form von Kreisringsegmenten aufweisen, die gleichförmig auf einem (14, 20) oder zwei (1, 2) metallischen Ringen verteilt und an ihrem jeweiligen Ring mit ihren einander gegenüberliegenden Seiten befestigt sind, und

– die ersten un zweiten auf den piezoelektrischen Elementen vorgesehenen Elektroden jeweils von dem/den zugeordneten metallischen Ring/en sowie einer Metallisierung (15) der zweiten Seite der piezoelektrischen Elemente derart gebildet sind, daß sie entweder eine Mehrzahl von Elektroden bilden, von denen jede einem piezoelektrischen Element zugeordnet ist, oder eine einzige den piezoelektrischen Elementen ein- und derselben Ebene gemeinsame Elektrode bilden, derart, daß eine translatorische Verlagerung der Einheit, gegebenenfalls kombiniert mit einer Modifikation der Winkelposition der Einheit, relativ zu dem Referenzsystem ermöglicht wird.

2. Vorrichtung nach Anspruch 1, dadurch gekennzeichnet, daß sie einen einzigen metallischen Ring (20) umfaßt, daß die piezoelektrischen Elemente (7, 8) in einer Anzahl von drei vorgesehen sind und voneinander getrennt sind, daß der metallische Ring drei Auskragungen (3) für die Befestigung an einem der genannten ersten bzw. zweiten Organe aufweist, angeordnet zwischen den piezoelectrischen Elementen, und daß er an dem anderen der genannten ersten und zweiten Organe an drei Punkten befestigt ist, die sich zwischen den drei Auskragungen befinden.

3. Vorrichtung nach Anspruch 1, dadurch gekennzeichnet, daß sie einen einzigen metallischen Ring (20) umfaßt, daß die piezoelektrischen elemente (18, 19) auf den beiden Seiten des metallischen Ringes (20) symmetrisch relativ zu dem Ring befestigt sind und daß die symmetrisch beidseits des Ringes angeordneten piezoelektrischen Elemente invers polarisiert sind.

4. Vorrichtung nach Anspruch 3, dadurch gekennzeichnet, daß die benachbarten piezoelektrischen Elemente in geradzahliger Anzahl vorgesehen und invers polarisiert sind.

5. Vorrichtung nach Anspruch 1, dadurch gekennzeichnet, daß die zwischen den ersten und zweiten Elektroden angelegten Spannungen identisch sind und daß die Verlagerungen der Einheit in der Asche der Vorrichtung erfolgen.

6. Vorrichtung nach Anspruch 1, dadurch gekennzeichnet, daß die zwischen den ersten und zweiten Elektroden angelegten Spannungen derart sind, daß die Winkelposition der Einheit relativ zur Achse der Vorrichtung modifiziert wird.

7. Binokulares Mikroskop für die gleichzeitige Beobachtung von zwei Ebenen ein- und desselben Objekts, dadurch gekennzeichnet, daß es eine Vorrichtung nach Anspruch 1 umfaßt, plaziert zwischen dem Objektiv und dem Korpus des Mikroskops derart, daß seine Fokalisationsebene im Ansprechen auf eine an die piezoelektrischen Elemente angelegte Spannung geändert wird und daß Mittel vorgesehen sind zum aufeinanderfolgenden Sperren jedes der beiden Okulare synchron mit einer Veränderung der angelegten Spannungen derart, daß das Bild des Objekts in zwei unterschiedlichen Fokalisationsebenen gleichzeitig durch die beiden Okulare des Mikroskops beobachtbar ist.

8. Binokulares Mikroskop nach Anspruch 7, dadurch gekennzeichnet, daß die Sperrmittel eine Scheibe (32) umfassen, die eine transparente Hälfte und eine opake Hälfte aufweist und zur Drehung angetrieben werden mit der gleichen Frequenz wie die der angelegten Spannungen.

**Claims**

1. Device for the fine adjustment of a unit with respect to a reference system, comprising a plurality of thin piezoelectric elements (7, 8; 18, 19) disposed between a first member (5) integral with the said reference system and a second member (6) integral with the said unit, a first and second electrode being provided on the said piezoelectric elements, the said piezoelectric elements and the said electrodes being arranged to curve in response to a voltage applied between the said first and second electrodes; characterised in that:

– the thin piezoelectric elements (7, 8; 18, 19) are disposed between the said first member (5) and the said second member (6) either in one plane (8) or in two planes (7, 8; 18, 19) and are in the form of segments of a circular ring distributed evenly on one (14, 20) or two (1, 2) metal annuluses and fixed to their respective annulus by means of their faces opposite each other; and

– the first and second electrodes provided on the said piezoelectric elements consist, respectively, of the metal annulus and electroplating (15) on the second face of the said piezoelectric elements so as to form either a plurality of electrodes, each of them being associated with one piezoelectric element; or a single electrode common to the piezoelectric elements in any one plane;

so as to allow a movement in translation of the said unit whether or not combined with a change in the angular position of the said unit with respect to the said reference system.

2. Device according to claim 1, characterised in that it has a single metal annulus (20), in that the said piezoelectric elements (7, 8) are three in number and are separated from each other, in that the said metal annulus has three lugs (3) for fixing to one of the said first and second members disposed between the said piezoelectric elements and in that it is fixed to the other one of the said first and second members at three points located between the said three lugs.

3. Device according to claim 1, characterised in that it has a single metal ring (20), in that the said piezoelectric elements (18, 19) are fixed to the two faces of the said metal annulus (20) symmetrically with respect to the said annulus and in that the symmetrical piezoelectric elements located on each side of the said annulus are of opposite polarities.

4. Device according to claim 3, characterised in that the adjacent piezoelectric elements are even in number and are of opposite polarities.

5. Device according to claim 1, characterised in that the voltages applied between the said first and second electrodes are identical and in that the movements of the said unit are in the axis of the said device.

6. Device according to claim 1, characterised in that the voltages applied between the said first and second electrodes are such that the angular position of the said unit is changed with respect to the axis of the said device.

7. Binocular microscope for the simultaneous observation of two planes on the same object, characterised in that it has a device according to claim 1 placed between the lens and the body of the microscope so as to change its focal plane in response to a voltage applied to the said piezoelectric elements and in that means are provided for successively closing off each of the two eyepieces in synchronism with a variation in the said voltages applied so that the image of the said object in two different focal planes can be seen simultaneously through the two eyepieces of the microscope.

8. Binocular microscope according to claim 7, characterised in that the means of closing off comprise a disc (32) having one half transparent and another half opaque and are driven in rotation at the same frequency as that of the said voltages applied.

Fig. 1

Fig. 2

Fig. 3

Fig. 4

Fig. 4a

Fig. 4b



Fig. 8

Fig. 5

Fig. 6

Fig.7

Fig. 9